# EUROPEAN PATENT SPECIFICATION

(11) **EP 2 837 710 B1**
(45) Date of publication and mention of the grant of the patent: **15.05.2019**
(21) Application number: 12831198.2
(22) Date of filing: 05.09.2012
(51) Int. Cl.: C23C 14/34, C22C 9/05, H01L 21/285, H01L 21/28

(54) **PRODUCTION METHOD FOR A HIGH-PURITY COPPER-MANGANESE-ALLOY SPUTTERING TARGET**
VERFAHREN ZUR HERSTELLUNG EINES HOCHREINEN KUPFER-MANGAN-LEGIERUNGS-SPUTTERTARGET
PROCÉDÉ DE FABRICATION DE CIBLE DE PULVÉRISATION D'UN ALLIAGE CUIVRE-MANGANÈSE D'UNE GRANDE PURETÉ

(30) Priority: 14.09.2011 JP 2011200228
(43) Date of publication of application: 18.02.2015
(73) Proprietor: JX Nippon Mining & Metals Corporation, Tokyo 100-8164 (JP)
(72) Inventor: NAGATA, Kenichi, Kitaibaraki-shi Ibaraki 319-1535 (JP); OTSUKI, Tomio, Kitaibaraki-shi Ibaraki 319-1535 (JP); OKABE, Takeo, Kitaibaraki-shi Ibaraki 319-1535 (JP); MAKINO, Nobuhito, Kitaibaraki-shi Ibaraki 319-1535 (JP); FUKUSHIMA, Atsushi, Kitaibaraki-shi Ibaraki 319-1535 (JP)
(74) Representative: Hoarton, Lloyd Douglas Charles
(86) International application number: PCT/JP2012/072541
(87) International publication number: WO 2013/038962

(56) References cited:
- WO-A1-2004/083482
- WO-A1-2008/041535
- JP-A- 2005 232 509
- JP-A- 2006 073 863
- JP-A- 2007 051 351
- US-A1- 2009 101 495

## Description

### [Technical Field]

The present invention relates to a method for producing a high-purity copper-manganese-alloy that has a self-diffusion suppression function useful and suitable for forming a semiconductor copper alloy line and can effectively prevent contamination of the periphery of the line due to diffusion of active copper. The invention particularly relates to a method for producing a high-purity copper-manganese-alloy sputtering target with less particle generation.

### BACKGROUND ART

Conventionally, Al alloys, of which specific resistance is about 3.0 µΩ cm, were used as a metal line material of semiconductor devices. However, a copper line having a lower resistance, of which specific resistance is about 2.0 µΩ·cm, has been put into practical use with miniaturization of metal lines. A copper line is generally formed by forming a diffusion barrier layer of, for example, Ta or TaN in a line or a via hole and then forming a film of copper by sputtering. Copper having a high purity of 5 to 6 N is usually produced from electrolytic copper having a purity of about 4 N (excluding gas components) as a crude metal by a wet or dry purification process, and the purified copper is used as a sputtering target.

As described above, copper is very effective for semiconductor metal lines, however, copper itself is a very active metal and easily diffuses, and thus causes a problem of contaminating a Si substrate or its periphery through the semiconductor Si substrate or the insulating film thereon. In particular, with progress in miniaturization of lines, the problem cannot be sufficiently prevented by the conventional diffusion barrier layer of Ta or TaN only, and copper line materials themselves also need to be improved. Accordingly, as a copper line material, a Cu-Mn alloy, which is a copper alloy prepared by adding manganese (Mn) to copper (Cu), having a self-diffusion suppression function by forming a barrier layer by itself through a reaction of Mn in the Cu-Mn alloy with oxygen in an insulating film, has been proposed.

The semiconductor copper alloy line is formed using a copper-manganese alloy sputtering target. In such a semiconductor copper alloy line, fine particles cause a problem of affecting a circuit with progresses of miniaturization, density growth, and integration of semiconductor devices and with progresses of miniaturization and increase in number of metal line layers, though conventionally the particles have not caused any problem. Hence, it is an urgent issue to more strictly prevent the generation of particles during sputtering and to reduce particles on a semiconductor wafer.

The followings are examples of the Cu-Mn alloy sputtering target:
Patent Literature 1 describes a sputtering target composed of 0.1 to 20.0 at.% of Mn, 0.05 at.% or less of inevitable impurity elements having diffusion coefficients lower than the self-diffusion coefficient of Cu, and the remainder being Cu;
Patent Literature 2 describes a sputtering target composed of 0.1 to 1.0 at.% of B as an additive element, 0.1 to 2.0 at.% of Mn and/or Ni, and the remainder being Cu and inevitable impurities;
Patent Literature 3 describes a sputtering target composed of 0.1 to 1.0 at.% of B as an additive element, 0.1 to 2.0 at.% of an element (including Mn) that forms a compound with B, and the remainder being Cu and inevitable impurities;
Patent Literature 4 describes a sputtering target composed of at least one component selected from the group consisting of V, Nb, Fe, Co, Ni, Zn, and Mg and at least one component selected from the group consisting of Sc, Al, Y, and Cr in a total amount of 0.005 to 0.5% by mass, 0.1 to 5 ppm of oxygen, and the remainder being Cu and inevitable impurities;
Patent Literature 5 describes a sputtering target composed of oxygen in an amount of higher than 6% by mole and 20% by mole or less, at least one selected from Mo, Mn, Ca, Zn, Ni, Ti, Al, Mg, and Fe in a total amount of 0.2 to 5% by mole, and the remainder being Cu and inevitable impurities; and
Patent Literature 6 describes a sintered sputtering target material composed of a metal powder of Mn, B, Bi, or Ge and an alloy powder or sintered metal containing X (including Cu) and Y, in which the amount of crystal grains having an average particle diameter of 0.1 to 300 µm is 50% or more, and the amount of gas included is 600 ppm or less.

However, there is a problem that these sputtering targets are not necessarily sufficient for preventing particle generation during sputtering.

Furthermore, the present applicant has proposed a semiconductor device metal line material, which is a sputtering target for forming a semiconductor copper alloy line and composed of Mn in an amount of 0.05 to 5 wt.%, at least one element selected from Sb, Zr, Ti, Cr, Ag, Au, Cd, In, and As in a total amount of 10 wt ppm or less, and the remainder being Cu (see Patent Literature 7).

This is effective for enhancing the self-diffusion suppression function, but the purpose thereof is not suppression of particle generation.

The present applicant has previously disclosed a semiconductor copper alloy line material composed of a Cu-Mn alloy (see Patent Literature 8), in particular, has proposed a sputtering target composed of 0.05 to 20 wt.% of Mn, a total amount of 500 wt ppm or less of Be, B, Mg, Al, Si, Ca, Ba, La, and Ce, and the remainder being Cu and inevitable impurities.

This is also effective for enhancing the self-diffusion suppression function, but the purpose thereof is not suppression of particle generation.

Regarding the suppression of particle generation, a sputtering target composed of 0.6 to 30% by mass of Mn, 40 ppm or less of metal impurities, 10 ppm or less of oxygen, 5 ppm or less of nitrogen, 5 ppm or less of hydrogen, 10 ppm or less of carbon, and the remainder being Cu has been described (see Patent Literature 9).

However, this describes that particle generation can be suppressed by reducing the total amount of impurities contained in the target, and it is unclear which impurity element specifically contributes to generation of particles.

### Citation List

### Patent Literature

Patent Literature 1: Japanese Patent No. 4065959
Patent Literature 2: Japanese Patent Laid-Open No. 2009-97085
Patent Literature 3: Japanese Patent Laid-Open No. 2010-248619
Patent Literature 4: Japanese Patent Laid-Open No. 2002-294437
Patent Literature 5: Japanese Patent Laid-Open No. 2008-311283
Patent Literature 6: Japanese Patent Laid-Open No. 2009-741127
Patent Literature 7: Japanese Patent Laid-Open No. 2006-73863
Patent Literature 8: International Publication No. WO2008/041535
Patent Literature 9: Japanese Patent Laid-Open No. 2007-51351
   US 2009/101495 discloses an Mn-containing copper alloy sputtering target.

### SUMMARY OF THE INVENTION

### [Technical Problem]

It is an object of the present invention to suppress particle generation during sputtering by adding an appropriate amount of Mn element to copper and controlling the amount of carbon. This enables successful formation of a metal line (via) of fine semiconductor devices and can improve the yield and the reliability of semiconductor products, which have been progressing in miniaturization and integration. The invention provides a high-purity copper-manganese-alloy sputtering target useful for forming a semiconductor copper alloy line having a self-diffusion suppression function, capable of effectively preventing the periphery of the metal line from being contaminated by diffusion of active Cu, and having excellent, for example, electron migration (EM) resistance and corrosion resistance.

### [Solution to Problem]

In order to solve the above-mentioned problems, the present inventors have diligently studied and, as a result, have found that the main component of the particles is carbon and that there is a correlation between the amount of carbon contained in a target and the number of particles. The inventors further discovered that by adding an appropriate amount of Mn element to copper and controlling the carbon amount, a high-purity copper alloy sputtering target which enables to considerably reduce the amount of particles generated during sputtering and is useful for forming a semiconductor copper alloy line can be obtained.

Based on these findings, the present invention provides a method of producing a high-purity copper-manganese-alloy sputtering target as claimed.

### [Effects of Invention]

The high-purity copper-manganese-alloy sputtering target of the present invention can successfully form a metal line (via) of fine semiconductor devices by suppressing particle generation during sputtering through control of the amount of carbon. A copper alloy line film formed using the high-purity copper-manganese-alloy sputtering target of the present invention has excellent effects of effectively preventing contamination of the periphery of the metal line due to diffusion of active Cu and improving, for example, electron migration (EM) resistance and corrosion resistance.

### DETAILED DESCRIPTION OF THE INVENTION

As described above, the high-purity copper-manganese-alloy sputtering target of the present invention is composed of 0.05 to 20 wt.% of Mn, 2 wt ppm or less of C, and the remainder being Cu and inevitable impurities. In formation of a film by sputtering the target, the number of particles composed of C or C and at least one element selected from Mn, Si, and Mg and having a diameter of 0.08 µm or more on a wafer is 50 or less on average.

In the present invention, the amount of Mn contained in a Cu alloy is 0.05 wt.% or more and 20 wt.% or less. An amount of Mn less than 0.05 wt.% reduces the self-diffusion suppression function whereas an amount of Mn exceeding 20 wt.% increases the resistance and thereby disadvantageously reduces the performance in terms of semiconductor copper alloy lines. More preferably, a copper alloy contains Mn at 0.5 to 10 wt.%.

Furthermore, since carbon contamination occurs from melting materials and apparatus members during the melting step, the Mn content may directly affect the amount of carbon that causes particle generation. Accordingly, the Mn content is required to be exactly controlled within the above-mentioned range.

In addition, in the present invention, the carbon (C) content in the high-purity copper-manganese-alloy sputtering target is 2 wt ppm or less, preferably 1 wt ppm or less. The impurities contained in the target cause particle generation, and it is therefore desirable to reduce the amount as much as possible. In particular, since carbon (C) directly affects particles being generated during sputtering of a high-purity copper-manganese-alloy target, it is necessary to sufficiently control it.

The number of particles generated during sputtering the target obtained according to the present invention having a diameter of 0.20 µm or more on a 300-mm wafer is 30 or less on average and preferably 10 or less on average. In addition, regarding particles having a diameter of 0.08 µm or more, the number of the particles on a 300-mm wafer is 50 or less on average and preferably 20 or less on average. The suppression of particle generation allows successful formation of a metal line (via) of fine semiconductor devices and can improve the yield and the reliability of semiconductor products which have been progressing in miniaturization and integration.

The component of individual particles generated in sputtering using the target obtained according to the present invention is carbon (C), at least one element selected from Mn, Si, and Mg, or a compound composed of carbon (C) and at least one selected from Mn, Si, and Mg. The particles might only be one type of these particles of different components or a mixture of two or more types of these particles of different components. Note that the Mn is derived from addition and that the Si and the Mg are derived from the crucible used in production of the target.

In the production of the high-purity copper-manganese-alloy sputtering target in the present invention, high-purity copper having a purity of 6 N or more and manganese, an additive element, having a purity of 5 N or more are molten in a carbon crucible. Alternatively, high-purity copper having a purity of 6 N or more is molten in a carbon crucible in advance, and manganese having a purity of 4 N is then added thereto so as to give a desired component composition.

Herein, the important point is melting conditions. The melting temperature is 1000°C to 1400°C. A temperature lower than 1000°C does not allow sufficient melting reaction, whereas a temperature higher than 1400°C disadvantageously causes contamination of carbon from the carbon crucible. The melting period of time is 10 to 30 minutes. A melting time shorter than 10 minutes does not allow sufficient melting reaction, whereas a melting time longer than 30 minutes disadvantageously causes contamination of carbon from the carbon crucible.

A high-purity copper-manganese-alloy ingot having a predetermined component composition can be obtained by casting the resulting alloy. Subsequently, the copper-manganese-alloy ingot is hot-forged at about 500°C to 900°C and cold-rolled or, as needed, hot-rolled at 500°C to 900°C to give a rolled sheet. The hot-rolling is performed when rolling is difficult because of occurrence of cracking during cold-rolling due to hardening with an increase in amount of manganese. The critical mass of Mn is about 5%, but this critical mass for rolling depends on rolling amount and can be arbitrarily selected and be varied according to the claims.

The rolled sheet is further heat-treated at 300°C to 600°C (in hot-rolling, at 500°C to 800°C) and is then bonded to a backing plate, followed by finishing processing. Thus, a sputtering target assembly is produced from the high-purity copper-manganese-alloy.

It is readily understood by those skilled in the art that these production steps can be appropriately selected depending on the component composition, thickness, and size of the target.

### [Examples]

The present invention will now be described by examples. The following examples are intended to facilitate understanding and do not limit the present invention. That is, modifications and other examples based on the claims are included in the present invention.

### Example 1

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 1 wt.%.

The molten copper-manganese alloy prepared by charging of the Mn and melting at 1200°C for 20 minutes was cast in a water-cooled copper mold under a high vacuum atmosphere to give an ingot. Subsequently, the surface layer of the produced ingot was removed to give a size of ϕ160×60t, followed by hot-forging at 800°C into ϕ200. Subsequently, cold-rolling and hot-rolling at 800°C were performed to give a size of ϕ380×10t.

Subsequently, after heat treatment at 600°C for 1 hour, the entire target was quenched to give a target material. The target material was machined into a target having a diameter of 430 mm and a thickness of 7 mm, which was further diffusion bonded to a Cu alloy backing plate into a sputtering target assembly.

### Example 2

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 10 wt.%.

The molten copper-manganese alloy prepared by charging of the Mn and melting at 1200°C for 20 minutes was cast in a water-cooled copper mold under a high vacuum atmosphere to give an ingot. Subsequently, the surface layer of the produced ingot was removed to give a size of ϕ160×60t, followed by hot-forging at 900°C into ϕ200. Subsequently, cold-rolling and hot-rolling at 900°C were performed to give a size of ϕ380×10t.

Subsequently, after heat treatment at 600°C for 1 hour, the entire target was quenched to give a target material. The target material was machined into a target having a diameter of 430 mm and a thickness of 7 mm, which was further diffusion bonded to a Cu alloy backing plate into a sputtering target assembly.

### Example 3

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 1 wt.%.

The molten copper-manganese alloy prepared by charging of the Mn and melting at 1200°C for 20 minutes was cast in a water-cooled copper mold under a high vacuum atmosphere to give an ingot. Subsequently, the surface layer of the produced ingot was removed to give a size of ϕ160×190t, followed by hot-forging at 900°C into ϕ200. Subsequently, cold-rolling and hot-rolling at 900°C were performed to give a size of ϕ700×10t.

Subsequently, after heat treatment at 600°C for 1 hour, the entire target was quenched to give a target material. The target material was machined into a target having a diameter of 650 mm and a thickness of 7 mm. The target was further machined so as to have a diameter of 430 mm and a thickness of 7 mm, which was diffusion bonded to a Cu alloy backing plate into a sputtering target assembly.

### Example 4

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 10 wt.%.

The molten copper-manganese alloy prepared by charging of the Mn and melting at 1200°C for 20 minutes was cast in a water-cooled copper mold under a high vacuum atmosphere to give an ingot. Subsequently, the surface layer of the produced ingot was removed to give a size of ϕ160×190t, followed by hot-forging at 900°C into ϕ200. Subsequently, cold-rolling and hot-rolling at 900°C were performed to give a size of ϕ700×10t.

Subsequently, after heat treatment at 600°C for 1 hour, the entire target was quenched to give a target material. The target material was machined into a target having a diameter of 650 mm and a thickness of 7 mm. The target was further machined so as to have a diameter of 430 mm and a thickness of 7 mm, which was diffusion bonded to a Cu alloy backing plate into a sputtering target assembly.

### Comparative Example 1

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 1 wt.%.

The molten copper-manganese alloy prepared by charging of the Mn and melting at 1500°C for 40 minutes was cast in a water-cooled copper mold under a high vacuum atmosphere to give an ingot. Subsequently, the surface layer of the produced ingot was removed to give a size of ϕ160×60t, followed by hot-forging at 800°C into ϕ200. Subsequently, cold-rolling and hot-rolling at 800°C were performed to give a size of ϕ380×10t.

Subsequently, after heat treatment at 600°C for 1 hour, the entire target was quenched to give a target material. The target material was machined into a target having a diameter of 430 mm and a thickness of 7 mm, which was further diffusion bonded to a Cu alloy backing plate into a sputtering target assembly.

### Comparative Example 2

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 10 wt.%.

The molten copper-manganese alloy prepared by charging of the Mn and melting at 1500°C for 40 minutes was cast in a water-cooled copper mold under a high vacuum atmosphere to give an ingot. Subsequently, the surface layer of the produced ingot was removed to give a size of ϕ160×60t, followed by hot-forging at 900°C into ϕ200. Subsequently, cold-rolling and hot-rolling at 900°C were performed to give a size of ϕ380×10t.

Subsequently, after heat treatment at 600°C for 1 hour, the entire target was quenched to give a target material. The target material was machined into a target having a diameter of 430 mm and a thickness of 7 mm, which was further diffusion bonded to a Cu alloy backing plate into a sputtering target assembly.

### Comparative Example 3

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 10 wt.%.

The molten copper-manganese alloy prepared by charging of the Mn and melting at 1500°C for 40 minutes was cast in a water-cooled copper mold under a high vacuum atmosphere to give an ingot. Subsequently, the surface layer of the produced ingot was removed to give a size of ϕ160×190t, followed by hot-forging at 900°C into ϕ200. Subsequently, cold-rolling and hot-rolling at 900°C were performed to give a size of ϕ700×10t.

Subsequently, after heat treatment at 600°C for 1 hour, the entire target was quenched to give a target material. The target material was machined into a target having a diameter of 650 mm and a thickness of 7 mm. The target was further machined so as to have a diameter of 430 mm and a thickness of 7 mm, which was diffusion bonded to a Cu alloy backing plate into a sputtering target assembly.

### Comparative Example 4

High-purity copper (Cu) having a purity of 6 N was melted in a carbon crucible under a high vacuum atmosphere. High-purity manganese (Mn) having a purity of 5 N was charged into the molten copper. The amount of Mn was adjusted to 10 wt.%.

The molten copper-manganese alloy prepared by charging of the Mn and melting at 1500°C for 40 minutes was cast in a water-cooled copper mold under a high vacuum atmosphere to give an ingot. Subsequently, the surface layer of the produced ingot was removed to give a size of ϕ160×190t, followed by hot-forging at 900°C into ϕ200. Subsequently, cold-rolling and hot-rolling at 900°C were performed to give a size of ϕ700×10t.

Subsequently, after heat treatment at 600°C for 1 hour, the entire target was quenched to give a target material. The target material was machined into a target having a diameter of 650 mm and a thickness of 7 mm. The target was further machined so as to have a diameter of 430 mm and a thickness of 7 mm, which was diffusion bonded to a Cu alloy backing plate into a sputtering target assembly.

The high-purity copper alloy sputtering targets were each evaluated by forming a thin film with a thickness of 600 nm on a 300-mm monocrystalline silicon wafer covered with silicon oxide under sputtering conditions shown below and particles generated during the sputtering was investigated. The particles on the wafer surface were counted with a particle counter available from KLA-Tencor Corporation, and the average number in 20 wafers was determined. Table 1 shows the comparison results of the number of particles of 0.20 µm or more and particles of 0.08 µm or more which were generated during sputtering.

### (Sputtering conditions)

Apparatus: Endura manufactured by Applied Materials, Inc.
Power source: direct current system
Power: 40 kW
Ultimate vacuum: 5×10⁻⁶ Pa
Atmospheric gas composition: Ar
Sputtering gas pressure: 55 Pa
Sputtering time: 6 seconds

**[Table 1]**

| | Melting conditions | | Carbon amount (wt ppm) | Number of particles on wafer (average) | |
|---|---|---|---|---|---|
| | Temperature (°C) | Time (min) | | 0.20 µm or more (Number/Wafer) | 0.08 µm or more (Number/Wafer) |
| Example 1 | 1200 | 20 | 1 | 2.2 | 9.9 |
| Example 2 | 1200 | 20 | 2 | 5.4 | 12.1 |
| Example 3 | 1200 | 20 | 1 | 2.3 | 10.2 |
| Example 4 | 1200 | 20 | 2 | 5.3 | 11.9 |
| Comparative Example 1 | 1500 | 40 | 5 | 37.3 | 98.6 |
| Comparative Example 2 | 1500 | 40 | 10 | 42.7 | 129.3 |
| Comparative Example 3 | 1500 | 40 | 5 | 39.8 | 109.2 |
| Comparative Example 4 | 1500 | 40 | 10 | 52.3 | 139.2 |

| | | | | | |
|---|---|---|---|---|---|
| 1 Wafer = 300 mm ϕ | | | | | |

As shown in Table 1, when the carbon amount was 1 wt ppm in Examples 1 and 3, the numbers of particles generated and having a diameter of 0.20 µm or more were respectively 2.2 and 2.3, and the numbers of particles having a diameter of 0.08 µm or more were respectively 9.9 and 10.2.

Whereas, when the carbon amount was 2 wt ppm in Examples 2 and 4, the numbers of particles having a diameter of 0.20 µm or more were respectively 5.4 and 5.3 and the numbers of particles having a diameter of 0.08 µm or more were respectively 12.1 and 11.9.

In contrast, when the carbon amount was 5 wt ppm in Comparative Examples 1 and 3, the numbers of particles having a diameter of 0.20 µm or more were respectively 37.3 and 39.8 and the average numbers of particles having a diameter of 0.08 µm or more were respectively 98.6 and 109.2.

Meanwhile, when the carbon amount was 10 wt ppm in Comparative Examples 2 and 4, the average numbers of particles having a diameter of 0.20 µm or more were respectively 42.7 and 52.3 and the average numbers of particles having a diameter of 0.08 µm or more and respectively 129.3 and 139.2.

Thus, there was an obvious difference in generation of particles, i.e., a carbon amount of 2 wt ppm or less gave satisfactory results of significantly reducing particles.

In addition, it was revealed that the generation of particles depends on the amount of carbon and does not depend on the size of a target.

### [Industrial Applicability]

The present invention provides a method for producing a copper-manganese-alloy sputtering target that effectively suppresses the particle generation during sputtering by adding an appropriate amount of Mn element to copper and controlling the amount of carbon. In particular, the target produced according to the invention can successfully form a metal line (via) of fine semiconductor devices and thereby shows an excellent effect of improving the yield and the reliability of semiconductor products, which have been progressing in miniaturization and integration. In addition, the target is useful for forming a semiconductor copper-manganese-alloy line having a self-diffusion suppression function, capable of effectively preventing the periphery of the line from being contaminated by diffusion of active Cu, and having excellent, for example, electron migration (EM) resistance and corrosion resistance

## Claims

1. A method of producing a high-purity copper-manganese-alloy sputtering target comprising 0.05 to 20 wt.% of Mn, 2 wt ppm or less of C, the remainder being Cu and inevitable impurities including Si and Mg, wherein the copper has a purity of 99.9999 wt% (6N) or more and the manganese has a purity of 99.999 wt% (5N) or more; or the copper has a purity of 99.9999 wt% (6N) or more and is melted in advance and the manganese has a purity of 99.99 wt% (4N) or more and is added to the molten copper, comprising:
melting copper and manganese in a carbon crucible at 1000°C to 1400°C for 10 to 30 minutes to form a copper-manganese-alloy;
casting the alloy to form an ingot;
hot-forging the ingot at 500°C to 900°C; then
cold-rolling the ingot and/or hot-rolling the ingot at 500°C to 900°C to provide a rolled sheet; and then
heat-treating the cold rolled sheet at 300°C to 600°C or heat-treating the hot rolled sheet at 500°C to 800°C;
bonding to a backing plate; and finishing processing to obtain the target.

2. The method of claim 1, wherein the high-purity copper-manganese-alloy sputtering target comprises 0.5 to 10 wt.% of Mn.

3. The method of any preceding claim, wherein the high-purity copper-manganese-alloy sputtering target comprises 1 wt ppm or less of C.

## Patentansprüche

1. Verfahren zur Herstellung eines hochreinen Kupfer-Mangan-Legierungs-Sputtertargets umfassend 0,05 bis 20 Gew.-% Mn, 2 Gew.-ppm oder weniger C, wobei der Rest Cu und unvermeidbare Verunreinigungen einschließlich Si und Mg ist, worin das Kupfer eine Reinheit von 99,9999 Gew.-% (6N) oder mehr aufweist und das Mangan eine Reinheit von 99,999 Gew.-% (5N) oder mehr aufweist; oder das Kupfer eine Reinheit von 99,9999 Gew.-% (6N) oder mehr aufweist und im Voraus geschmolzen wird und das Mangan eine Reinheit von 99,99 Gew.-% (4N) oder mehr aufweist und dem geschmolzenen Kupfer zugegeben wird, umfassend:
Schmelzen von Kupfer und Mangan in einem Kohletiegel bei 1000 °C bis 1400 °C für 10 bis 30 Minuten, um eine Kupfer-Mangan-Legierung zu bilden;
Gießen der Legierung, um einen Block zu bilden;
Warmschmieden des Blocks bei 500 °C bis 900 °C; anschließend Kaltwalzen des Blocks und/oder Warmwalzen des Blocks bei 500 °C bis 900 °C, um ein gewalztes Blech bereitzustellen; und anschließend Wärmebehandeln des warmgewalzten Blechs bei 300 °C bis 600 °C oder Wärmebehandeln des warmgewalzten Blechs bei 500 °C bis 800 °C;
Bonden an eine Trägerplatte; und Fertigbearbeitung, um das Target zu erhalten.

2. Verfahren nach Anspruch 1, worin das hochreine Kupfer-Mangan-Legierungs-Sputtertarget 0,5 bis 10 Gew.-% Mn umfasst.

3. Verfahren nach einem vorhergehenden Anspruch, worin das hochreine Kupfer-Mangan-Legierungs-Sputtertarget 1 Gew.-ppm oder weniger C umfasst.

## Revendications

1. Procédé de fabrication d'une cible de pulvérisation cathodique d'un alliage de cuivre-manganèse de haute pureté comprenant entre 0,05 et 20 % en poids de Mn, 2 ppm en poids ou moins de C, le reste étant Cu et les impuretés inévitables incluant Si et Mg, dans lequel le cuivre a une pureté égale ou supérieure à 99,9999 % en poids (6N) et le manganèse a une pureté égale ou supérieure à 99,999 % en poids (5N) ; ou le cuivre a une pureté égale ou supérieure à 99,9999 % en poids (6N) et est fondu à l'avance et le manganèse a une pureté égale ou supérieure à 99,99 % en poids (4N) et est ajouté au cuivre fondu, consistant à :
faire fondre le cuivre et le manganèse dans un creuset de carbone entre 1000°C et 1400°C pendant 10 à 30 minutes pour former un alliage cuivre-manganèse ;
couler l'alliage pour former un lingot ;
forger à chaud le lingot entre 500°C et 900°C ; puis
laminer à froid le lingot et/ou laminer à chaud le lingot entre 500°C et 900°C pour fournir une feuille laminée ; puis
traiter à chaud la feuille laminée à froid entre 300°C et 600°C ou traiter à chaud la feuille laminée à chaud entre 500°C et 800°C ;
coller à une plaque de support ; et
finir le processus pour obtenir la cible.

2. Procédé selon la revendication 1, dans lequel la cible de pulvérisation cathodique d'un alliage de cuivre-manganèse de haute pureté comprend entre 0,5 et 10 % en poids de Mn.

3. Procédé selon l'une quelconque des revendications précédentes, dans lequel la cible de pulvérisation cathodique d'un alliage de cuivre-manganèse de haute pureté comprend 1 ppm en poids ou moins de C.
